# EUROPEAN PATENT APPLICATION

(11) **EP 4 369 536 A2**
(43) Date of publication of application: **15.05.2024**
(21) Application number: 23204680.5
(22) Date of filing: 19.10.2023
(51) Int. Cl.: H01S 5/183

(54) **POLARIZED/LENSED BACK-SIDE EMITTING (BSE) VERTICAL-CAVITY SURFACE-EMITTING LASER (VCSEL)**

(30) Priority: 19.10.2022 US 202263417503 P; 16.10.2023 US 202318487368
(71) Applicant: II-VI Delaware, Inc., Wilmington, DE 19890 (US)
(72) Inventor: IAZIKOV, Dmitri, Wilmington, 19890 (US); TATARCZAK, Anna, Wilmington, 19890 (US); LICHTENSTEIN, Norbert, Wilmington, 19890 (US); STEIB, Michael, Wilmington, 19890 (US); TAN, Jason Lin-Chew, Wilmington, 19890 (US); KOCOT, Chris, Wilmington, 19890 (US); MELGAR, Alirio, Wilmington, 19890 (US); LAURAIN, Alex, Wilmington, 19890 (US); MUTTER, Lukas, Wilmington, 19890 (US)
(74) Representative: Schmidt, Christian

(57) **Abstract**

This disclosure describes a vertical-cavity surface-emitting laser (VCSEL) structure with a locked polarization and collimating optical element. The VCSEL structure comprises a grating, an optical emitter such as a lens and a plurality of GaAs/AlGaAs mirrors between the grating and the optical emitter. The grating located between the mirror stacks and above or below the active region is able to polarize incident waves of the VCSEL structure.

## Description

### BACKGROUND

Limitations and disadvantages of traditional vertical-cavity surface-emitting lasers will become apparent to one of skill in the art, through comparison of such approaches with some aspects of the present method and system set forth in the remainder of this disclosure with reference to the drawings.

### BRIEF SUMMARY

Systems and methods are provided for producing a back-side emitting, vertical-cavity surface-emitting laser (BSE VCSEL) with locked polarization and collimating optics, substantially as illustrated by and/or described in connection with at least one of the figures, as set forth more completely in the claims.

### BRIEF DESCRIPTION OF THE DRAWINGS

FIG. 1 illustrates an example polarized/lensed BSE VCSEL structure, with dielectric mirrors, in accordance with various example implementations of this disclosure.
FIG. 2 illustrates an example polarized/lensed BSE VCSEL structure, with regrown DBR mirrors, in accordance with various example implementations of this disclosure.
FIG. 3 illustrates an example polarized/lensed BSE VCSEL structure, with wafer bonding, in accordance with various example implementations of this disclosure.

### DETAILED DESCRIPTION

A vertical-cavity surface-emitting laser (VCSEL) is a type of semiconductor laser diode with laser beam emission perpendicular from the top surface, contrary to conventional edge-emitting semiconductor lasers which emit from surfaces formed by cleaving the individual chip out of a wafer. VCSELs are used in various laser products, including computer mice, fiber optic communications, laser printers, Face ID, and smart glasses.

As disclosed, a back-side emitting (BSE) VCSEL with locked polarization and collimating optics is proposed. Addressable BSE VCSEL arrays with emitters or zones may perform different optical functions.

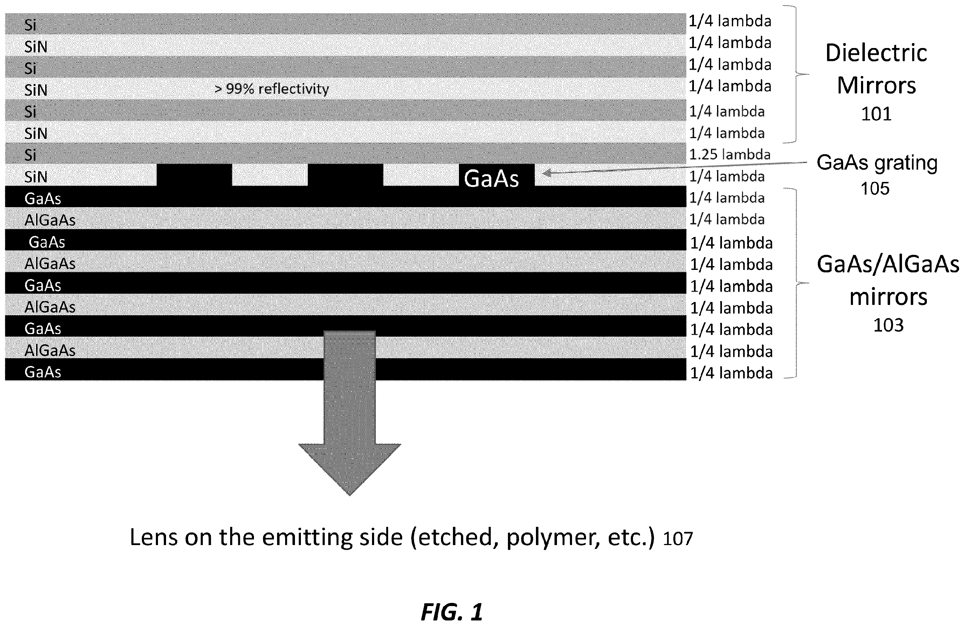

FIG. 1 illustrates an example polarized/lensed BSE VCSEL structure, with dielectric mirrors, in accordance with various example implementations of this disclosure.

The non-emitting side, of the BSE VCSEL structure in FIG. 1, comprises dielectric mirrors 101. For example, the dielectric mirrors 101 may comprise alternating quarter wavelength layers of Si and SiN.

The emitting side, of the BSE VCSEL structure in FIG. 1, comprises GaAs/AIGaAs mirrors 103. The GaAs/AIGaAs mirrors 103 may be plasma enhanced chemical vapor deposited (PECVD) alternating quarter wavelength layers of GaAs and AlGaAs. There may be more layers in the GaAs/AIGaAs mirrors 103 than the dielectric mirrors 101.

The dielectric mirrors 101 and the GaAs/AIGaAs mirrors 103 are separated by a grating 105 operable to polarize incident waves of the BSE VCSEL. The grating 105 may comprise areas of GaAs. An optical emitter, such as a lens 107, a focusing metasurface or diffractive optical element (DOE), is located on the emitting side. The surface of the emitter on the emitting side may be covered in an anti-reflective (AR) coating layer.

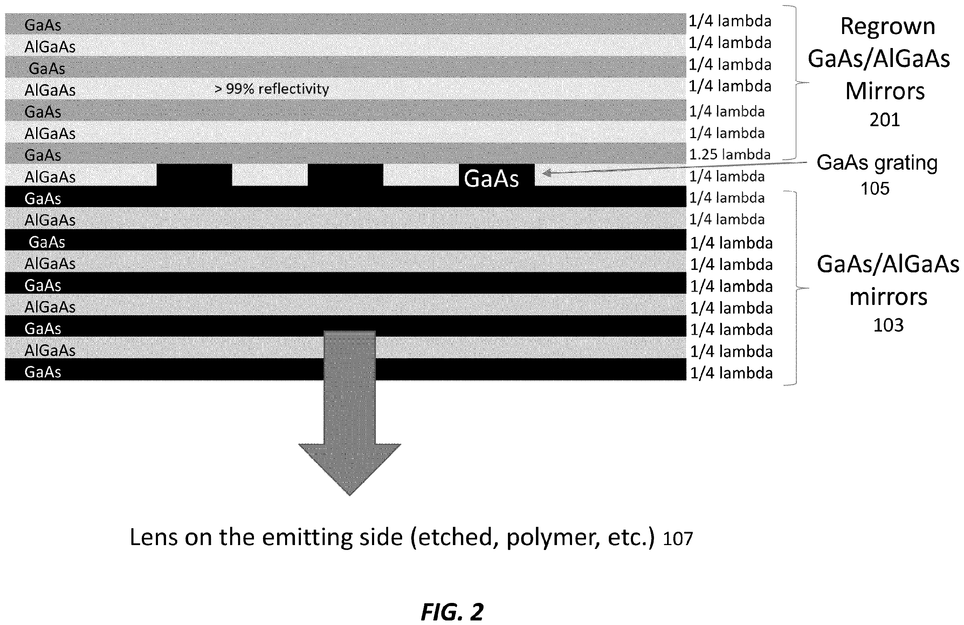

FIG. 2 illustrates an example polarized/lensed BSE VCSEL structure, with regrown DBR, in accordance with various example implementations of this disclosure.

The non-emitting side, of the BSE VCSEL structure in FIG. 2, comprises regrown GaAs/AIGaAs mirrors 201. The regrown layers immediately above the grating layer 105 may not be planar, which may aid the polarization locking.

The emitting side, of the BSE VCSEL structure in FIG. 2, comprises GaAs/AIGaAs mirrors 103. The GaAs/AIGaAs mirrors 103 may be plasma enhanced chemical vapor deposited (PECVD) alternating quarter wavelength layers of GaAs and AlGaAs. There may be more layers in the GaAs/AIGaAs mirrors 103 than the dielectric mirrors 101.

The dielectric mirrors 101 and the GaAs/AIGaAs mirrors 103 are separated by a grating 105 operable to polarize incident waves of the BSE VCSEL. The grating 105 may comprise areas of GaAs. An optical emitter, such as a lens 107, a focusing metasurface or a DOE, is located on the emitting side. The surface of the emitter on the emitting side may be covered in an AR coating layer.

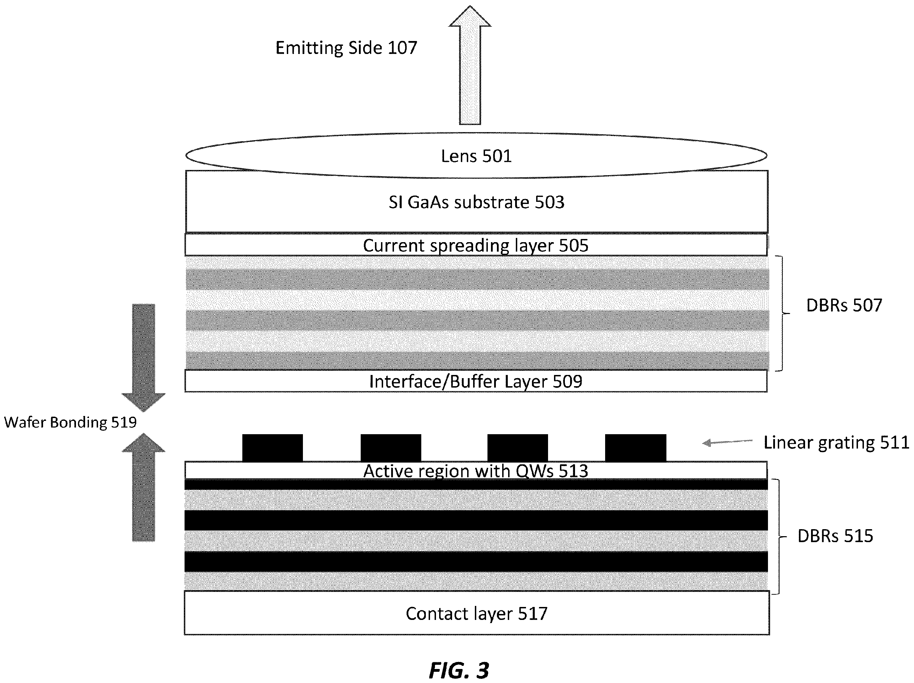

FIG. 3 illustrates an example polarized/lensed BSE VCSEL structure, with wafer bonding, in accordance with various example implementations of this disclosure.

The BSE VCSEL structure in FIG. 5 comprises a lens 501, a semi-insulating (SI) GaAs substrate 503, a current spreading layer 505, a first DBR 507, a cladding layer 509, a linear grating 511, one or more quantum wells (QWs) 513, a second DBR 515 and a contact layer 517. All the layers in the stack, with an exception of the SI GaAs substrate 503, may be doped to support current injection into the active region.

The linear GaAs/Air polarizing grating 511, operable to polarize incident waves of the BSE VCSEL, is inserted near the VCSEL cavity 513 by wafer bonding 519. Optics 501, operable to collimate incident waves of the BSE VCSEL, are located on the emitting side 107 of the substrate 503. An optical emitter, such as a lens, metasurface, or DOE, is located on the emitting side. The surface of the emitter on the emitting side may be covered in an AR coating layer.

The present method and/or system may be realized in hardware, software, or a combination of hardware and software. The present methods and/or systems may be realized in a centralized fashion in at least one computing system, or in a distributed fashion where different elements are spread across several interconnected computing systems. Any kind of computing system or other apparatus adapted for carrying out the methods described herein is suited. A typical implementation may comprise one or more application specific integrated circuit (ASIC), one or more field programmable gate array (FPGA), and/or one or more processor (e.g., x86, x64, ARM, PIC, and/or any other suitable processor architecture) and associated supporting circuitry (e.g., storage, DRAM, FLASH, bus interface circuits, etc.). Each discrete ASIC, FPGA, Processor, or other circuit may be referred to as "chip," and multiple such circuits may be referred to as a "chipset." Another implementation may comprise a non-transitory machine-readable (e.g., computer readable) medium (e.g., FLASH drive, optical disk, magnetic storage disk, or the like) having stored thereon one or more lines of code that, when executed by a machine, cause the machine to perform processes as described in this disclosure. Another implementation may comprise a non-transitory machine-readable (e.g., computer readable) medium (e.g., FLASH drive, optical disk, magnetic storage disk, or the like) having stored thereon one or more lines of code that, when executed by a machine, cause the machine to be configured (e.g., to load software and/or firmware into its circuits) to operate as a system described in this disclosure.

As used herein the terms "circuits" and "circuitry" refer to physical electronic components (i.e. hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As used herein, "and/or" means any one or more of the items in the list joined by "and/or". As an example, "x and/or y" means any element of the three-element set {(x), (y), (x, y)}. As another example, "x, y, and/or z" means any element of the seven-element set {(x), (y), (z), (x, y), (x, z), (y, z), (x, y, z)}. As used herein, the term "exemplary" means serving as a non-limiting example, instance, or illustration. As used herein, the terms "e.g.," and "for example" set off lists of one or more non-limiting examples, instances, or illustrations. As used herein, circuitry is "operable" to perform a function whenever the circuitry comprises the necessary hardware and code (if any is necessary) to perform the function, regardless of whether performance of the function is disabled or not enabled (e.g., by a user-configurable setting, factory trim, etc.). As used herein, the term "based on" means "based at least in part on." For example, "x based on y" means that "x" is based at least in part on "y" (and may also be based on z, for example).

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

## Claims

1. A system, the system comprising:
a vertical-cavity surface-emitting laser (VCSEL) structure comprising a grating operable to polarize waves incident on the grating.

2. The system of claim 1, wherein the grating comprises GaAs.

3. The system of claim 1, wherein the VCSEL structure is back-side emitting (BSE).

4. The system of claim 1, wherein the VCSEL structure comprises a plurality of dielectric mirrors, operably coupled to the grating, on a non-emitting side of the VCSEL structure.

5. The system of claim 4, wherein the plurality of dielectric mirrors comprise alternating quarter wavelength layers of Si and SiN.

6. The system of claim 1, wherein the VCSEL structure comprises a plurality of GaAs/AIGaAs mirrors, operably coupled to the grating, on an emitting side of the VCSEL structure.

7. The system of claim 6, wherein the plurality of GaAs/AIGaAs mirrors comprise alternating quarter wavelength layers of GaAs and AlGaAs.

8. The system of claim 6, wherein the plurality of GaAs/AIGaAs mirrors are plasma enhanced, chemical vapor deposited (PECVD).

9. The system of claim 6, wherein the plurality of GaAs/AIGaAs mirrors are regrown.

10. The system of claim 6, wherein two regions of the plurality of GaAs/AIGaAs mirrors are separated by an active region.

11. The system of claim 6, wherein the VCSEL structure comprises a semi-insulating GaAs substrate between the plurality of GaAs/AIGaAs mirrors and an optical emitter.

12. The system of claim 1, wherein the grating comprises a linear GaAs/Air grating that is generated via wafer bonding.

13. The system of claim 1, wherein the VCSEL structure is one of a plurality of addressable VCSEL structures in an array comprising one or more zones, and wherein an addressable VCSEL structure in a zone of the one or more zones is operable to perform an optical function.

14. The system of claim 1, wherein the VCSEL structure comprises an optical emitter on an emitting side of the VCSEL structure.

15. The system of claim 14, wherein the optical emitter it operable for beam shaping.

16. The system of claim 14, wherein the optical emitter is a lens.

17. The system of claim 16, wherein a diffractive optical element comprises the lens.

18. The system of claim 14, wherein the optical emitter is a metasurface.

19. The system of claim 14, wherein the optical emitter is a diffractive optical element.

20. The system of claim 14, wherein the optical emitter comprises an anti-reflective coating.
